# EUROPEAN PATENT APPLICATION

(11) **EP 2 940 717 A1**
(43) Date of publication of application: **04.11.2015**
(21) Application number: 13869293.4
(22) Date of filing: 09.10.2013
(51) Int. Cl.: H01L 21/301

(54) **DICING-SHEET SUBSTRATE FILM AND DICING SHEET**

(30) Priority: 28.12.2012 JP 2012286707
(71) Applicant: LINTEC Corporation, Tokyo 173-0001 (JP)
(72) Inventor: TAYA Naoki, Tokyo 173-0001 (JP); UEDA Masashi, Tokyo 173-0001 (JP); ITO Masaharu, Tokyo 173-0001 (JP)
(74) Representative: Raynor, Stuart Andrew
(86) International application number: PCT/JP2013/077496
(87) International publication number: WO 2014/103467

(57) **Abstract**

A dicing sheet base film (2) includes a resin layer (A). The resin layer (A) contains: a norbornene-based resin (a1) that is a thermoplastic resin containing a structural unit derived from a norbornene-based compound; a styrene-based elastomer (a2); and an olefin-based thermoplastic resin (a3) other than the norbornene-based resin (a1) and other than the styrene-based elastomer (a2). The dicing sheet base film (2) suppresses the occurrence of dicing debris, in particular filament-like dicing debris, during the dicing of a cut object without imparting physical energy such as electron rays and γ rays, and has sufficient expandability in the expanding process.

## Description

### [Technical Field]

The present invention relates to a dicing sheet to which a cut object such as a semiconductor wafer is applied when the cut object is cut and separated into small element pieces, and also relates to a base film used for the dicing sheet.

### [Background Art]

Semiconductor wafers such as silicon and gallium arsenide wafers and various types of packages (which may be collectively referred to as "cut object(s)" hereinafter) are manufactured in a large diameter state, and these are cut and separated into small element pieces (referred to as "chip(s)" hereinafter) (dicing process).

A cut object to be supplied to the dicing process may be such that, for the purpose of ensuring the handling property of the cut object and chips in the dicing process and subsequent processes, a dicing sheet comprising a base film and a pressure sensitive adhesive layer provided thereon is preliminarily applied to a surface of the cut object opposite to the side which a cutting tool for cutting comes close to. Such a dicing sheet may typically use a polyolefin-based film or a polyvinyl chloride-based film as the base film, for example.

According to commonly-used full-cut dicing as a specific method for the dicing process, a rotating round blade is used for cutting a cut object. In the full-cut dicing, to ensure that the cut object applied thereto with the dicing sheet is completely cut over the entire surface, the pressure sensitive adhesive layer may also be cut beyond the cut object, and a part of the base film may further be cut.

During this operation, dicing debris comprising materials that constitute the pressure sensitive adhesive layer and the base film may arise from the dicing sheet, and the obtained chips may be contaminated with the dicing debris. One form of such dicing debris is filament-like dicing debris that attaches onto a dicing line or to an area near the cross-section of each chip separated by dicing.

If the chip is enclosed in a package while a large amount of the filament-like dicing debris as described above remains on the chip, then the filament-like dicing debris attached to the chip will be decomposed by heat used for the enclosing, and the thermally decomposed substance may destroy the package and/or cause operational failure in a device obtained. Such filament-like dicing debris is difficult to be removed by washing, and the yield of the dicing process will thus be considerably reduced due to the occurrence of filament-like dicing debris.

When dicing a package as the cut object in which plural chips are enclosed by using cured resin, a dicing blade having a thicker blade width is used and the cutting depth in dicing also becomes deeper than the case of dicing a semiconductor wafer. Consequently, the amount of the base film to be cut and removed during the dicing may increase compared with the case of a semiconductor wafer, and this may result in a tendency that the generated amount of filament-like dicing debris also increases. Therefore, when a dicing sheet is used to perform dicing to manufacture semiconductor packages, it is further needed to prevent the occurrence of the filament-like dicing debris.

After the dicing process, the cut object having been cut may then be subjected to subsequent processes, such as washing, expanding and picking-up processes. As such, it is also required for a dicing sheet to have excellent expandability in the expanding process.

To suppress the occurrence of such dicing debris, Patent Literature 1 discloses an invention which uses, as the base film of a dicing sheet, a polyolefin-based film having been exposed to electron rays or γ (gamma) rays with 1-80 Mrad. In this invention, it appears that a resin that constitutes the base film is crosslinked through the exposure to electron rays or γ rays thereby to suppress the occurrence of dicing debris.

Patent Literature 1 exemplifies, as materials for the polyolefin-based film to be exposed to electron rays or γ rays, resins such as polyethylene, polypropylene, polymethylpentene, ethylene-vinyl acetate copolymer, ethylene-(meth)acrylic acid copolymer, ethylene-methyl (meth)acrylate copolymer, ethylene-ethyl (meth)acrylate copolymer, ethylene-ionomer copolymer, ethylene-vinyl alcohol copolymer, and polybutene.

Patent Literature 2 exemplifies a pressure sensitive adhesive tape for dicing a semiconductor in which: the tape is obtained by applying a pressure sensitive adhesive on one surface of a base film; the base film comprises at least two layers; the melting point of a resin in a layer of the base film that is in contact with the pressure sensitive adhesive layer is 130-240°C; at least one layer of the two layers is a resin composition layer that is in contact with the lower surface of the layer in contact with the pressure sensitive adhesive layer; and the resin composition layer comprises 20-400 mass parts of a hydrogenated product of styrene-butadiene copolymer to 100 mass parts of polypropylene-based resin.

Patent Literature 3 discloses, as a film imparted with expandability in the expanding process, a dicing film comprising: a base material layer that contains random propylene and olefin-based elastomer; and a pressure sensitive adhesive layer laminated on the base material layer.

### [Prior Art Literature]

### [Patent Literature]

[Patent Literature 1] JP05-211234A
[Patent Literature 2] JP2005-174963A
[Patent Literature 3] JP2011-216595A

### [Summary of the Invention]

### [Problems to be solved by the Invention]

However, the film described in Patent Literature 1 has a tendency that the production cost increases compared with that of a standard base film, because the exposure to electron rays or γ rays is performed after the resin as described above is once formed into a film-like shape, and an additional process for production is required. The base film of Patent Literature 2 is not able to sufficiently prevent the occurrence of filament-like dicing debris. The dicing film described in Patent Literature 3 has excellent expandability, but is not able to sufficiently prevent the occurrence of filament-like dicing debris.

The present invention has been created in view of such actual circumstances, and an object of the present invention is to provide a base film for a dicing sheet which suppresses the occurrence of dicing debris, in particular filament-like dicing debris, during the dicing of a cut object without imparting physical energy such as electron rays and γ rays, and which has sufficient expandability (expanding property) in the expanding process. Another object of the present invention is to provide a dicing sheet that comprises such a base film for a dicing sheet.

### [Means for solving the Problems]

In order to achieve the above objects, first, the present invention provides a dicing sheet base film comprising a resin layer (A), the resin layer (A) comprising: a norbornene-based resin (a1) that is a thermoplastic resin containing a structural unit derived from a norbornene-based compound; a styrene-based elastomer (a2); and an olefin-based thermoplastic resin (a3) other than the norbornene-based resin (a1) and other than the styrene-based elastomer (a2) (Invention 1).

Here, examples of the "dicing sheet" in the present invention include a dicing/die bonding sheet, and also include one which has another base film and pressure sensitive adhesive layer for being attached thereto with a ring frame. Further, the term "sheet" as used in the present invention encompasses the concept of a "tape."

The "norbornene-based resin" in the present invention refers to a thermoplastic resin that contains a structural unit derived from a norbornene-based compound, wherein the "norbornene-based compound" means one or more types of compounds selected from the group consisting of norbornene, a compound having a ring structure that includes a bicyclo ring associated with norbornene (e.g., dicyclopentadiene), and derivatives thereof, in the present invention.

The "styrene-based elastomer (a2)" in the present invention means a copolymer that contains a structural unit derived from styrene or its derivative (also referred to as a "styrene-based compound" in the present description), i.e., a material that has elasticity, like rubber, within a temperature region including an ordinary temperature and also has thermoplasticity.

The "olefin-based thermoplastic resin (a3) other than the norbornene-based resin (a1) and other than the styrene-based elastomer (a2)" in the present invention means collectively olefin-based thermoplastic resins that do not have a structural unit derived from a norbornene-based compound and a structural unit derived from a styrene-based compound, and may be simply referred to as a "first olefin-based resin (a3)." An "olefin-based thermoplastic resin" means a thermoplastic resin which contains a structural unit derived from olefin and in which the mass ratio of monomers of olefin in the total monomers before polymerization for giving the resin (a3) is 1.0 mass% or more.

According to the above invention, the resin layer (A) comprises: the norbornene-based resin (a1) ; the styrene-based elastomer (a2); and the olefin-based thermoplastic resin (a3) other than the norbornene-based resin (a1) and other than the styrene-based elastomer (a2), thereby to suppress the occurrence of filament-like debris during the dicing. Therefore, dicing debris that is generated during the dicing of a cut object can effectively be reduced without imparting physical energy, such as electron rays and γ rays. Moreover, there can be obtained a base film having sufficient expandability in the expanding process.

In the above invention (Invention 1), it may be preferred that the styrene-based elastomer (a2) comprises a styrene-conjugate diene copolymer (Invention 2). Among such styrene-conjugate diene copolymers, a hydrogenated styrene-conjugate diene copolymer may be more preferred.

In the above invention (Invention 1, 2), it may be preferred that the styrene-based elastomer (a2) contains styrene with a content ratio of 5 mass% or more and 50 mass% or less (Invention 3).

In the above invention (Invention 1 to 3), it may be preferred that the styrene-based elastomer (a2) in the resin layer (A) has a content of 10 mass% or more and 60 mass% or less (Invention 4).

In the above invention (Invention 1 to 4), it may be preferred that the norbornene-based resin (a1) has a density of 0.98 g/cm³ or more at 23°C (Invention 5).

In the above invention (Invention 1 to 5), it may be preferred that the norbornene-based resin (a1) has a liquefaction temperature of 225°C or lower (Invention 6).

Here, the "liquefaction temperature" in the present invention refers to a value obtained by a "Koka"-type flow tester (examples of the product include Flowtester Capillary Rheometer, model number: CFT-100D, available from SHIMADZU CORPORATION). Specifically, while the temperature of a sample is risen with a rate of temperature rise of 10°C/min, a stroke displacement rate (mm/min) which varies as the temperature rises is measured by setting a load of 49.05 N and using a die having a hole shape of ϕ2.0 mm and a length of 5.0 mm, and a temperature dependency chart of the stroke displacement rate is obtained. When the sample is a thermoplastic resin, the stroke displacement rate increases with a trigger of the sample temperature reaching a softening point and reaches a certain peak, and thereafter once decreases. After reaching a minimum point due to this decrease, the stroke displacement rate increases rapidly because the liquefaction of whole of the sample progresses. In the present invention, the liquefaction temperature is defined, when the sample temperature is risen above the softening point, as a temperature that gives the minimum value of the stroke displacement rate which appears after the stroke displacement rate has once reached the peak.

In the above invention (Invention 1 to 6), it may be preferred that the norbornene-based resin (a1) in the resin layer has a content of 3 mass% or more and 40 mass% or less (Invention 7).

In the above invention (Invention 1 to 7), it may be preferred that the resin layer (A) has a total luminous transmittance of 75% or more in an ultraviolet region (Invention 8).

The "total luminous transmittance" as used in the present invention means the minimum value of a total luminous transmittance obtained by measurement within a range of an ultraviolet region (300 nm to 400 nm) for a film that is formed of the same material as that of the base film and has a thickness of 100 µm.

In the above invention (Invention 1 to 8), it may be preferred that the dicing sheet base film comprises a resin layer (B) placed at a side of one of surfaces of the resin layer (A) and the resin layer (B) comprises at least one layer (Invention 9).

In the above invention (Invention 9), it may be preferred that the resin layer (B) has a tensile elastic modulus of 50 MPa or more and 500 MPa or less at 23°C and a fracture elongation of 100% or more (Invention 10).

In the above invention (Invention 9 or 10), it may be preferred that the resin layer (B) contains an ethylene-(meth)acrylic acid copolymer (Invention 11).

In the above invention (Invention 1 to 11), it may be preferred that the dicing sheet base film has a tensile elastic modulus of 80 MPa or more and 1,000 MPa or less at 23°C (Invention 12).

Second, the present invention provides a dicing sheet comprising: the dicing sheet base film according to any one of the above inventions (1 to 12); and a pressure sensitive adhesive layer placed on the resin layer (A) of the film (Invention 13).

### [Advantageous Effect of the Invention]

According to the dicing sheet base film and the dicing sheet of the present invention, dicing debris that is generated during the dicing of a cut object can effectively be reduced without imparting physical energy, such as electron rays and γ rays. Moreover, the dicing sheet base film and the dicing sheet have sufficient expandability in the expanding process. Furthermore, the dicing sheet base film and the dicing sheet do not require any treatment using electron rays or γ rays, and can thus be easily manufactured.

### [Brief Description of Drawings]

[FIG. 1] FIG. 1 is a cross-sectional view of a dicing sheet according to an embodiment of the present invention.
[FIG. 2] FIG. 2 is a cross-sectional view of a dicing sheet according to another embodiment of the present invention.

### [Embodiments for Carrying out the Invention]

Description will now be directed to constitutional elements of a dicing sheet according to an embodiment of the present invention and a method of manufacturing the same, etc.

### 1. Base film

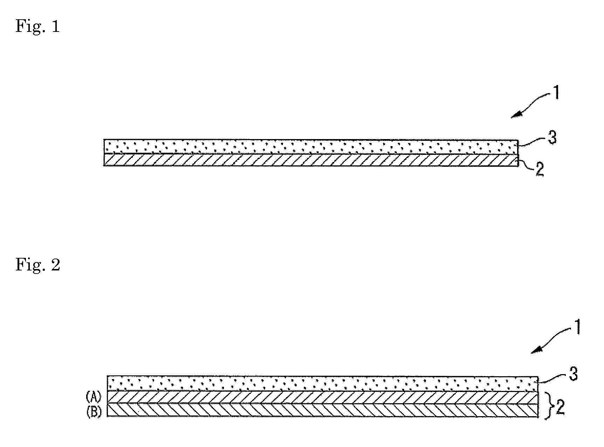

As shown in FIG. 1, dicing sheet 1 according to an embodiment of the present invention comprises, as a basic configuration, a base film 2 and a pressure sensitive adhesive layer 3 placed on the base film 2. This base film 2 comprises a resin layer (A), and may further comprise a resin layer (B) according to another embodiment (FIG. 2) as will be described later.

### (1) Resin layer (A)

The base film 2 may be a single layer or may comprise plural layers so long as the base film 2 comprises the resin layer (A). When the base film 2 comprises a single resin layer, the resin layer (A) as a single layer is the base film 2. When the base film 2 comprises plural resin layers, the location of the resin layer (A) is not particularly limited, but it may be preferred that at least one of main surfaces of the base film 2 is a surface of the above resin layer (A). In this case, for forming the pressure sensitive adhesive layer 3 on the base film 2 thereby to form the dicing sheet 1, it may be preferred that the pressure sensitive adhesive layer 3 is formed on the resin layer (A). The feature that the pressure sensitive adhesive layer 3 is formed on the resin layer (A) allows to effectively reduce the occurrence of dicing debris during the dicing of a cut object.

This resin layer (A) contains: a norbornene-based resin (a1) that is a thermoplastic resin of which at least one type of monomers is a norbornene-based compound; a styrene-based elastomer (a2); and an olefin-based thermoplastic resin (first olefin-based resin) (a3) other than the norbornene-based resin (a1) and other than the styrene-based elastomer (a2).

The feature that the resin layer (A) contains the norbornene-based resin (a1), the styrene-based elastomer (a2) and the first olefin-based resin (a3) allows to effectively reduce the occurrence of filament-like debris during the dicing. Moreover, a base film having sufficient expandability in the expanding process can be obtained.

The feature that the resin layer (A) contains the norbornene-based resin (a1) allows to obtain an effect of suppressing the occurrence of dicing debris in the dicing sheet and an effect of preventing the occurrence of blocking when winding the base film 2. In order that the norbornene-based resin (a1) takes an effective dispersion form in the resin layer (A) to suppress the occurrence of dicing debris so that the occurrence of dicing debris is stably suppressed, the norbornene-based resin (a1) in the resin layer (A) may preferably have a content of 3.0 mass% or more, more preferably 5.0 mass% or more, and particularly preferably 10 mass% or more. On the other hand, in order to suppress the deterioration of workability of the resin layer (A), the deterioration of expandability of the base film 2 and the like, the norbornene-based resin (a1) in the resin layer (A) may preferably have a content of 40 mass% or less, and more preferably 30 mass% or less.

The resin layer (A) of the base material 2 according to the present embodiment further contains the styrene-based elastomer (a2). Containing the styrene-based elastomer (a2) further enhances the effect of suppressing the occurrence of dicing debris and allows to impart excellent expandability. In order to stably obtain these effects, the styrene-based elastomer (a2) in the resin layer (A) may preferably have a content of 10 mass% or more, and more preferably 20 mass% or more. However, if the styrene-based elastomer (a2) is excessively contained in the resin layer (A), the resin layer (A) is unduly softened to deteriorate the handling ability because blocking is likely to occur in the base material 2, for example. Therefore, the styrene-based elastomer (a2) in the resin layer (A) may preferably have a content of 60 mass% or less, and more preferably 40 mass% or less.

The resin layer (A) of the base material 2 according to the present embodiment further contains the first olefin-based resin (a3) in addition to the norbornene-based resin (a1) and the styrene-based elastomer (a2). Containing the first olefin-based resin (a3) imparts the flexibility to the resin layer (A) to improve the expandability and the handling ability. In order to stably obtain this effect, the first olefin-based resin (a3) in the resin layer (A) may preferably have a content of 1.0 mass% or more, more preferably 5.0 mass% or more, and particularly preferably 30 mass% or more. If the first olefin-based resin (a3) is excessively contained in the resin layer (A), the resin layer (A) is unduly softened to deteriorate the handling ability because blocking is likely to occur in the base material 2, for example. Therefore, the first olefin-based resin (a3) in the resin layer (A) may preferably have a content of 80 mass% or less, and more preferably 70 mass% or less.

To reduce the possibility that the base film 2 fractures in the expanding process, the tensile elastic modulus at 23°C (referred simply to as a "tensile elastic modulus" hereinafter) of the resin layer (A) of the base film 2 according to the present embodiment may be 1,000 MPa or less. To more stably reduce this possibility of the fracture of the base film 2, the tensile elastic modulus of the resin layer (A) may preferably be 900 MPa or less, and more preferably 500 MPa or less.

On the other hand, unduly low tensile elastic modulus of the resin layer (A) may possibly lead to poor handling ability of the base film 2. Therefore, the tensile elastic modulus of the resin layer (A) may preferably be 50 MPa or more, more preferably 100 MPa or more, and particularly preferably 150 MPa or more.

Components that constitute the resin layer (A) will then be described in detail.

### (1-1) Norbornene-based resin (a1)

The norbornene-based resin (a1) is a thermoplastic resin of which at least one type of monomers is a norbornene-based compound.

As previously described, the norbornene-based compound refers to one or more types of compounds selected from the group consisting of norbornene (bicyclo[2.2.1]hept-2-ene), a compound having a ring structure that includes a bicyclo ring associated with norbornene (e.g., dicyclopentadiene), and derivatives thereof. Specific examples include norbornene, dicyclopentadiene, cyclopentadiene and tetracyclododecene.

It may be preferred that the norbornene-based resin (a1) has a bicyclo[2.2.1]heptane cyclic structure at the main chain or side chain.

It may be further preferred that the norbornene-based resin (a1) has a cyclic structure at the main chain (a structure in which a bicyclo cyclic portion constitutes a part of the above main chain). Examples of the resin (a1) that comprises such a structure include a ring-opening metathesis polymer hydrogenated polymer of norbornene-based monomer (specifically, available as ZEONEX (registered trademark) series from ZEON CORPORATION), a copolymer of norbornene and ethylene (specifically, available as TOPAS (registered trademark) series from POLYPLASTICS CO., LTD.), a copolymer based on ring-opening polymerization of dicyclopentadiene and tetracyclopentadodecene (specifically, available as ZEONOR (registered trademark) series from ZEON CORPORATION), a copolymer of ethylene and tetracyclododecene (specifically, available as APEL (registered trademark) series from Mitsui Chemicals, Inc.), and a cyclic olefin resin which includes a polar group and of which raw materials are dicyclopentadiene and methacrylic ester (specifically, available as ARTON (registered trademark) series from JSR Corporation).

Here, the norbornene-based resin (a1) may have a crosslinked structure. Any type of crosslinking agent may be used to provide a crosslinked structure. The crosslinked structure may be crosslinked between polymer molecules of one type that constitute the norbornene-based resin (a1), or crosslinked between polymer molecules of different types.

In view of the workability and other factors, the norbornene-based resin (a1) may preferably have a value of melt flow rate in compliance with JIS K7210: 1999 of 0.1 g/10 min or more at a temperature of 230°C and a load of 2.16 kgf. In order to stably achieve the suppression of the occurrence of dicing debris while ensuring high productivity (workability), the melt flow rate of the norbornene-based resin (a1) may preferably be 0.5 g/10 min or more and 50.0 g/10 min or less, and further preferably 1.0 g/10 min or more and 25.0 g/10 min or less.

It may be preferred that the tensile elastic modulus at 23°C of the norbornene-based resin (a1) is more than 1.5 GPa. Details of measurement method for the tensile elastic modulus will be described later in the examples. The tensile elastic modulus within this range allows to obtain the resin layer (A) which can suppress the occurrence of dicing debris. It may also be preferred that the tensile elastic modulus at 23°C of the norbornene-based resin (a1) is 2.0 GPa or more. The upper limit of the tensile elastic modulus at 23°C of the norbornene-based resin (a1) is not particularly limited from the viewpoint of suppressing the occurrence of dicing debris.

The norbornene-based resin (a1) may preferably have a liquefaction temperature of 225°C or lower, more preferably 200°C or lower, and still more preferably 180°C or lower. The liquefaction temperature refers to a minimum temperature at which the liquefaction of whole of a heated resin sample occurs when the sample is further heated beyond a state where the heated resin sample passes over the softening point thereby to increase the degree of freedom in deformation of molecules so that the intermolecular interaction is enhanced. The liquefaction temperature being 225°C or lower allows the norbornene-based resin (a1) to be dispersed moderately in the resin layer (A), and it can be possible to effectively suppress the occurrence of dicing debris. If the liquefaction temperature of the norbornene-based resin (a1) is unduly low, there may be a concern that the effect of suppressing the occurrence of dicing debris is difficult to be obtained. There may also be a concern that the surface of the resin layer (A) becomes brittle and chipping readily occurs at the cross-section region of the cut object during use as the dicing sheet 1. Therefore, it may be preferred that the lower limit of the liquefaction temperature is 100°C or higher.

In order to readily suppress the occurrence of dicing debris, it may be preferred that the density of the norbornene-based resin (a1) is 0.98 g/cm³ or more at 23°C.

The norbornene-based resin (a1) may be crystalline or non-crystalline, but may preferably be non-crystalline in order to readily suppress the occurrence of dicing debris. The norbornene-based resin (a1) may be constituted of one type of resin, or may also be a mixture of plural types of resins.

### (1-2) Styrene-based elastomer

The resin layer (A) of the base film 2 according to the present embodiment contains the styrene-based elastomer (a2). In the present description, the "styrene-based elastomer (a2)" means a copolymer that contains a structural unit derived from styrene or its derivative (styrene-based compound), i.e., a material that has elasticity, like rubber, within a temperature region including an ordinary temperature and also has thermoplasticity. According to the feature that the resin layer (A) contains the styrene-based elastomer (a2), the occurrence of dicing debris is suppressed and the expandability is improved.

Examples of the styrene-based elastomer (a2) include a styrene-conjugate diene copolymer and a styrene-olefin copolymer. In order to improve the expandability while suppressing the occurrence of dicing debris, the styrene-based elastomer (a2) may preferably contain a styrene-conjugate diene copolymer, and may more preferably consist of a styrene-conjugate diene copolymer.

Specific examples of the styrene-conjugate diene copolymer include: non-hydrogenated styrene-conjugate diene copolymers, such as styrene-butadiene copolymer, styrene-butadiene-styrene copolymer (SBS), styrene-butadiene-butylene-styrene copolymer, styrene-isoprene copolymer, styrene-isoprene-styrene copolymer (SIS) and styrene-ethylene-isoprene-styrene copolymer; and hydrogenated styrene-conjugate diene copolymers, such as styrene-ethylene/propylene-styrene copolymer (SEPS, hydrogenated product of styrene-isoprene-styrene copolymer) and styrene-ethylene-butylene-styrene copolymer (SEBS, hydrogenated product of styrene-butadiene copolymer). Examples of the commercially available products in the industrial field include Tufprene (available from Asahi Kasei Corp.), Kraton (available from Kraton Polymer Japan), Sumitomo TPE-SB (available from Sumitomo Chemical Company, Limited), Epofriend (available from Daicel Corporation), Rabalon (available from Mitsubishi Chemical Corporation), Septon (available from KURARAY CO., LTD.) and Tuftec (available from Asahi Kasei Corp).

The styrene-based elastomer (a2) may be any of a hydrogenated product and a non-hydrogenated product. When the styrene-based elastomer (a2) is a hydrogenated product, the compatibility to the norbornene-based resin (a1) and the first olefin-based resin (a3) is high, so that the total luminous transmittance of the resin layer (A) is enhanced. Therefore, when the pressure sensitive adhesive layer of the dicing sheet according to the present embodiment contains an ultraviolet curable-type pressure sensitive adhesive, it may be preferred that the styrene-based elastomer (a2) is a hydrogenated product. Examples of such a hydrogenated product include hydrogenated styrene-conjugate diene copolymers, such as styrene-ethylene-butylene-styrene copolymer (SEBS, hydrogenated product of styrene-butadiene copolymer) and styrene-ethylene/propylene-styrene copolymer (SEPS, hydrogenated product of styrene-isoprene copolymer). It may be particularly preferred that the styrene-based elastomer (a2) is such a hydrogenated styrene-conjugate diene copolymer.

In the total monomers used for forming the styrene-based elastomer (a2), the mass ratio of monomers comprising styrene-based compounds (referred also to as a "styrene content ratio" in the present description) may be 5 mass% or more and 50 mass% or less. If the styrene content ratio is unduly low, the property as an elastomer that contains a structural unit derived from styrene will be less likely to appear, and it may be difficult to obtain the effect of suppressing the occurrence of dicing debris. In order to stably obtain such an effect, the styrene content ratio may preferably be 5 mass% or more, and more preferably 10 mass% or more. If, on the other hand, the styrene content ratio is unduly high, it may be observed that the expandability of the base film 2 tends to deteriorate. Therefore, the styrene content ratio may preferably be 50 mass% or less, more preferably 40 mass% or less, and particularly preferably 34 mass% or less.

The styrene-based elastomer (a2) may be constituted of one type of resin, or may also be a mixture of plural types of resins.

### (1-3) First olefin-based resin

The olefin-based thermoplastic resin (first olefin-based resin) (a3) other than the above norbornene-based resin (a1) and other than the above styrene-based elastomer (a2) is a thermoplastic resin that contains a structural unit derived from an olefin, i.e., an olefin-based thermoplastic resin that does not contain a structural unit derived from a norbornene-based compound and a structural unit derived from a styrene-based compound.

Specific examples of the first olefin-based resin (a3) include: ethylene-based polymer, such as polyethylene (linear low-density polyethylene, low-density polyethylene, medium-density polyethylene, high-density polyethylene), ethylene-αolefin copolymer, ethylene-vinyl acetate copolymer, ethylene-(meth)acrylic acid copolymer and ethylene- (meth) acrylic ester copolymer; propylene-based resin such as polypropylene; polybutene; and polymethylpentene. Among them, polyethylene (low-density polyethylene, medium-density polyethylene, high-density polyethylene), ethylene-αolefin copolymer and propylene-based resin such as polypropylene may be preferred, and polyethylene (low-density polyethylene, medium-density polyethylene, high-density polyethylene) may be more preferred.

The ethylene content ratio in the polyethylene (mass ratio of ethylene in the polymer) may preferably be 20 mass% or more, more preferably 50 mass% or more, and further preferably 70 mass% or more.

The first olefin-based resin (a3) may comprise one type of resin, or may also be obtained by blending plural types.

Here, the first olefin-based resin (a3) may have a crosslinked structure. Any type of crosslinking agent may be used to provide a crosslinked structure. The crosslinked structure may be crosslinked between polymer molecules of one type that constitute the first olefin-based resin (a3), or crosslinked between polymer molecules of different types.

The first olefin-based resin (a3) according to the present embodiment may preferably have a melt flow index (190 °C, 2.16 kgf) of 0.5 g/10 min or more and 10 g/10 min or less, and more preferably 2.0 g/10 min or more and 7 g/10 min or less.

The tensile elastic modulus at 23°C of the first olefin-based resin (a3) is not particularly limited, but may ordinarily be 1.0 GPa or less, preferably 0.4 GPa or less, and more preferably 0.2 GPa or less, in order to suppress the occurrence of dicing debris and improve the expandability.

The liquefaction temperature of the first olefin-based resin (a3) is not particularly limited, but may preferably be 100°C or higher and 180°C or lower.

The density of the first olefin-based resin (a3) is not particularly limited. If the density of the first olefin-based resin (a3) is unduly low, the expandability of the base film 2 will deteriorate, and the surface of the resin layer (A) may become sticky thereby to increase the possibility that troubles occur during working process. In this respect, the density of the first olefin-based resin (a3) may preferably be 0.87 g/cm³ or more, and more preferably 0.900 g/cm³ or more.

The first olefin-based resin (a3) may be crystalline or non-crystalline. When the first olefin-based resin (a3) is crystalline, the melting peak temperature is not particularly limited, but may preferably be 90 °C or higher and 180 °C or lower, and more preferably 100°C or higher and 150°C or lower. It may be preferred that the height of a melting peak is 2.0 W/g or more, and the melting heat quantity ΔH is 70.0 J/g or more and 120.0 J/g or less. The melting peak can be measured using a differential scanning calorimeter (DSC, specific example may be Q2000 available from TA Instruments).

### (1-4) Other components in resin layer (A)

The resin layer (A) may contain other components in addition to the above norbornene-based resin (a1), styrene-based elastomer (a2) and first olefin-based resin (a3) to an extent that does not impair the effects of the present invention. Examples of such other components include: thermoplastic elastomer resins (excluding the styrene-based elastomer (a2)), such as isoprene rubber, nitrile rubber, acrylic rubber, urethane rubber, butadiene rubber and copolymers thereof; and various additives, such as pigment, flame retardant, plasticizer, antistatic, glidant and filler.

### (2) Resin layer (B)

When the base film 2 comprises a multilayer, the base film 2 may further comprise a resin layer (B) in addition to the above resin layer (A). In this case, the location of the resin layer (A) is not particularly limited, but it may be preferred that at least one of main surfaces of the base film 2 is a surface of the resin layer (A). Specifically, as shown in FIG. 2, it may be preferred that the base film 2 comprises the resin layer (B) formed of at least one layer which is placed at the side of one surface of the resin layer (A) and the dicing sheet 1 is configured by laminating the base film 2 and the pressure sensitive adhesive layer 3 on each other so that the pressure sensitive adhesive layer 3 is placed on the resin layer (A) of the base film 2.

When the base film 2 is a multilayer configured such that the resin layer (A) and the resin layer (B) are laminated on each other, the expandability of the base film 2 can be further improved.

It may be preferred that the resin layer (B) has a tensile elastic modulus of 50 MPa or more and 500 MPa or less and a fracture elongation of 100% or more. The tensile elastic modulus and the fracture elongation within the above ranges allow the resin layer (B) to have excellent flexibility and expandability, which can impart excellent expandability to the base film 2 configured such that the resin layer (A) and the resin layer (B) are laminated on each other.

If the tensile elastic modulus of the resin layer (B) exceeds 500 MPa, the flexibility of the resin layer (B) becomes poor so that the resin layer (B) readily fractures, and there is a concern that the expandability of the base film 2 deteriorates. On the other hand, the tensile elastic modulus of the resin layer (B) lower than 50 MPa may deteriorate the handling ability. Thus, the resin layer (B) may more preferably have a tensile elastic modulus of 55 MPa or more and 400 MPa or less, further preferably 60 MPa or more and 300 MPa or less, and particularly preferably 65 MPa or more and 200 MPa or less.

If the fracture elongation of the resin layer (B) is less than 100%, fracture readily occurs in the resin layer (B) when the dicing sheet 1 is expanded, and there is a concern that the expandability of the base film 2 deteriorates. More preferred fracture elongation of the resin layer (B) is 200% or more, and particularly preferred is 300% or more. The upper limit of the fracture elongation of the resin layer (B) is not particularly limited, but may ordinarily be 1,000% or less, and may also be about 800% or less.

It may be preferred that the ratio of the tensile elastic modulus of the resin layer (A) to the tensile elastic modulus of the resin layer (B) ([tensile elastic modulus of resin layer (A)]/[tensile elastic modulus of resin layer (B)], also referred to as an "elastic modulus ratio" in the present description) is 10 or less. If the elastic modulus ratio is unduly high, delamination is highly likely to occur between the resin layer (A) and the resin layer (B) in the expanding process. There is also a concern that curl occurs such that the resin layer (A) is located at the inside. In order to stably reduce the possibility of such problems, the elastic modulus ratio may preferably be 8 or less, and more preferably 4 or less. The lower limit of the elastic modulus ratio is not particularly limited, but may ordinarily be 1.0 or more. An elastic modulus ratio of less than 1.0 may cause a concern that the handling ability of the base film 2 deteriorates. In addition, troubles may possibly occur, such as fracture in the expanding process.

Examples of resin that constitutes the resin layer (B) include: an olef in-based resin that is a resin based on a polymer containing a structural unit derived from an olefin compound; polyester such as polyethylene terephthalate and polyethylene naphthalate; polyurethane; polyvinyl chloride; and polyamide.

Among these resins, olefin-based resin may be preferred as the resin that constitutes the resin layer (B). When the resin that constitutes the resin layer (B) is an olefin-based resin, the interfacial adhesion of the resin layer (B) to the above-described resin layer (A) will be enhanced, and it is possible to more stably reduce the possibility that the delamination occurs between the resin layer (A) and the resin layer (B).

Examples of the above olefin-based resin include polyethylene, polypropylene, polybutene, ethylene-propylene copolymer, ethylene-butene copolymer, ethylene-(meth)acrylic acid copolymer, ethylene-vinyl acetate copolymer, and ethylene-(meth)acrylic ester copolymer. One type of the olefin-based resin may be solely used, or a mixture of two or more types of polymers may also be used.

Among these copolymers, ethylene-(meth)acrylic acid copolymer may be preferred as the polymer of the resin that constitutes the resin layer (B) because such a copolymer allows the resin layer (B) to readily have enhanced toughness and to have enhanced interfacial adhesion to the resin layer (A). Here, the " (meth) acrylic acid" as used in the present description is intended to mean both of acrylic acid and methacrylic acid. The "ethylene-(meth)acrylic acid copolymer" may be ethylene-acrylic acid copolymer, or ethylene-methacrylic acid copolymer, or ethylene-acrylic acid-methacrylic acid copolymer.

The polymer of the resin layer (B) may preferably contain 70 mass% or more, more preferably 80 mass% or more, and further preferably 90 mass% or more of the above ethylene- (meth) acrylic acid copolymer to the whole of resin that constitutes the resin layer (B).

The resin layer (B) may contain other components than the above resin to an extent that does not impair the effects of the present invention. Examples of such components include various additives, such as pigment, flame retardant, plasticizer, antistatic, glidant and filler. Examples of the pigment include titanium dioxide and carbon black. Examples of the filler include organic materials such as melamine resin, inorganic materials such as fumed silica, and metal-based materials such as nickel particles.

In the dicing sheet 1 according to the present embodiment, the resin layer (B) is constituted of a single resin layer, but may also have a structure comprising a plurality of resin layers. In the latter case, the resin layer (B) comprising a plurality of resin layers may satisfy the above conditions of tensile elastic modulus and fracture elongation. In addition, an interlayer such as an adhesive layer may be present between the resin layer (A) and the resin layer (B).

### (3) Other features of base film

When, as shown in FIG. 1, the base film 2 is a single layer of the resin layer (A), the thickness of the resin layer (A) (i.e., the base film 2) may ordinarily be 10 µm or more and 500 µm or less, preferably 40 µm or more and 300 µm or less, and more preferably 60 µm or more and 200 µm or less.

When, as shown in FIG. 2, the base film 2 is a multilayer comprising the resin layer (A) and the resin layer (B), the thickness of the resin layer (A) may ordinarily be 10 µm or more and 300 µm or less, preferably 20 µm or more and 120 µm or less, and more preferably 40 µm or more and 100 µm or less. The thickness of the resin layer (A) within the above range can prevent the occurrence of dicing debris. The thickness of the resin layer (B) may ordinarily be 10 µm or more and 300 µm or less, preferably 40 µm or more and 120 µm or less, and particularly preferably 50 µm or more and 100 µm or less. The thickness of the base film 2 may ordinarily be 20 µm or more and 600 µm or less, preferably 40 µm or more and 300 µm or less, and more preferably 60 µm or more and 200 µm or less.

It may be preferred that the resin layer (A) according to the present embodiment has a total luminous transmittance of 75% or more in an ultraviolet region. In the present description, the "total luminous transmittance" means the minimum value of a total luminous transmittance obtained by measurement within a range of an ultraviolet region (300 nm to 400 nm) for a film that is formed of the same material as that of the base film 2 and has a thickness of 100 µm. This total luminous transmittance can be measured using a spectrophotometer according to a known method. Given that the total luminous transmittance of the resin layer (A) is 75% or more, when the pressure sensitive adhesive layer 3 contains an ultraviolet curable-type pressure sensitive adhesive and ultraviolet irradiation is performed from the side of the resin layer (A), for example, the ultraviolet rays can sufficiently reach the pressure sensitive adhesive layer, which may be preferable.

The tensile elastic modulus (tensile elastic modulus at 23°C) of the base film 2 according to the present embodiment may be 50 MPa or more and 1,000 MPa or less, and preferably 80 MPa or more and 1,000 MPa or less. If the tensile elastic modulus is less than 50 MPa, the handling ability of the base film 2 may possibly be poor. If the tensile elastic modulus of the base film 2 exceeds 1,000 MPa, problems may occur such as that the base film 2 fractures in the expanding process and that the dicing sheet 1 itself is detached from a ring frame because the load applied during the expanding process increases.

### (4) Method of manufacturing base film

Method of manufacturing the base film 2 is not particularly limited. Examples thereof include: a melt extrusion method, such as T-die method and round-die method; a calender method; and a solution method, such as dry method and wet method, and any method may be employed. Considering that all of the norbornene-based resin (a1), the styrene-based elastomer (a2) and the first olefin-based resin (a3)) contained in the resin layer (A) are thermoplastic resins, it may be preferred to employ the melt extrusion method or the calender method. Among them, when the melt extrusion method is employed for manufacturing, components that constitute the resin layer (A) may be kneaded, and film forming may be performed using a known extruder directly from the obtained kneaded components or from pellets which have been once manufactured from the obtained kneaded components.

When the base film 2 has the resin layer (B), the method of manufacturing is also not particularly limited, and may be freely selected. Any suitable method may be employed depending on the composition of the resin layer (B) and purposes. For example, the resin layer (A) and the resin layer (B) may be laminated on each other using coextrusion molding, or separately manufactured resin layers may be applied to each other such as by adhesive so as to be laminated.

### 2. Dicing sheet

The dicing sheet comprises a pressure sensitive adhesive layer that is placed on the base film. More specifically, the dicing sheet 1 may preferably be configured such that the pressure sensitive adhesive layer 3 is placed on the resin layer (A) of the base film 2. According to the feature that the pressure sensitive adhesive layer 3 is formed on the resin layer (A), it is possible to effectively reduce the dicing debris which is generated during the dicing of a cut object.

### (1) Pressure sensitive adhesive layer

Examples of the pressure sensitive adhesive to be used that constitutes the pressure sensitive adhesive layer 3 include, but are not limited to, those which are usually used for dicing sheets, such as rubber-based, acrylic-based, epoxy-based, silicone-based and polyvinyl ether-based pressure sensitive adhesives, and energy ray curable-type (including ultraviolet curable-type) and heat curable-type pressure sensitive adhesives may also be used. When the dicing sheet 1 according to the present embodiment is used as a dicing/die-bonding sheet, adhesives may be used, such as pressure sensitive adhesive, thermoplastic adhesive and B-stage adhesive, which have both functions of fixing wafer and adhering die.

The thickness of the pressure sensitive adhesive layer 3 may ordinarily be 3-100 µm, and preferably about 5-80 µm.

### (2) Release sheet

A release sheet may be laminated on the pressure sensitive adhesive layer 3. The release sheet for protecting the pressure sensitive adhesive layer 3 may be freely selected.

The release sheet to be used may be, but is not particularly limited, a sheet that has a release layer formed on a substrate by release treatment using a release agent. Examples of the substrate used for the release sheet include glassine paper, coated paper, polyethylene film, polypropylene film, polybutene film, polybutadiene film, polymethylpentene film, polyvinyl chloride film, vinyl chloride copolymer film, polyethylene terephthalate film, polyethylene naphthalate film, polybutylene terephthalate film, polyurethane film, ethylene-vinyl acetate film, ionomer resin film, ethylene-(meth)acrylic acid copolymer film, ethylene- (meth) acrylic ester copolymer film, polystyrene film, polycarbonate film, polyimide film, fluorine resin film, and crosslinked films thereof. Laminate film obtained by laminating a plurality of such films may also be used.

Examples of the release agent used in the release treatment include alkyd-based, silicone-based, fluorine-based, unsaturated polyester-based, polyolefin-based and wax-based release agents.

The thickness of the release sheet may ordinarily be, but is not particularly limited to, about 20-150 µm.

### 3. Method of manufacturing dicing sheet

The method of manufacturing the dicing sheet 1 consisting of a laminate of the above base film 2 and pressure sensitive adhesive layer 3 and other layers, such as a release sheet, which may be used as necessary, is not particularly limited.

Some exemplary methods of manufacturing the dicing sheet 1 may be as follows.
(i) The pressure sensitive adhesive layer 3 is formed on the release sheet, and the base film 2 is pressed and bonded onto the pressure sensitive adhesive layer 3 to be laminated. In this operation, the method of forming the pressure sensitive adhesive layer 3 may be freely selected.
   One exemplary method of forming the pressure sensitive adhesive layer 3 may be as follows. A coating agent is prepared which contains a pressure sensitive adhesive that constitutes the pressure sensitive adhesive layer 3 and if necessary further contains some solvent. The coating agent is applied to one main surface of the base film 2 provided by the resin layer (A) using a coater, such as roll coater, knife coater, roll knife coater, air knife coater, die coater, bar coater, gravure coater, and curtain coater. The layer comprising the coating agent on the base film 2 is dried thereby to form the pressure sensitive adhesive layer 3.
(ii) The pressure sensitive adhesive layer 3 is formed on the base film 2, and if necessary a release sheet is further laminated thereon. In this operation, the method of forming the pressure sensitive adhesive layer 3 may be freely selected as the above.
   In another example than the above methods of (i) and (ii), a pressure sensitive adhesive layer 3 separately formed in a sheet-like form may also be applied to the base film 2.

The embodiments heretofore explained are described to facilitate understanding of the present invention and are not described to limit the present invention. Therefore, it is intended that the elements disclosed in the above embodiments include all design changes and equivalents to fall within the technical scope of the present invention.

### [Examples]

The present invention will hereinafter be more specifically described with reference to examples etc, but the scope of the present invention is not limited to these examples etc.

### <Example 1>

### (Preparation of base film)

Raw material for extrusion of the resin layer (A) was obtained by melting and kneading 20 mass parts of cycloolefin copolymer (product name: TOPAS (registered trademark) 7010, available from POLYPLASTICS CO., LTD., density at 23°C: 1.02 g/cm³, liquefaction temperature (result obtained based on Exemplary Test 2 as will be described later, here and hereinafter): 136°C) as the norbornene-based resin (a1), 10 mass parts of a hydrogenated product of styrene-butadiene copolymer (SEBS, product name: Tuftec (registered trademark) H1041, available from Asahi Kasei Corp., styrene content ratio: 30 mass%) as the styrene-based elastomer (a2) and 70 mass parts of low-density polyethylene (product name: SUMIKATHENE (registered trademark) L705, available from Sumitomo Chemical Company, Limited) as the first olefin-based resin (a3), using a biaxial kneading machine (Labo-plastomill available from Toyo Seiki Seisaku-sho, LTD).

In addition, raw material for extrusion of the resin layer (B) was obtained by melting and kneading ethylene-methacrylic acid copolymer (product name: Nucrel (registered trademark) N0903HC, availablefrom DUPONT-MITSUI POLYCHEMICALS CO., LTD., content of acid originated from MAA: 9 mass%) using a biaxial kneading machine (Labo-plastomill available from Toyo Seiki Seisaku-sho, LTD).

The raw material for extrusion of the resin layer (A) and the raw material for extrusion of the resin layer (B) were subjected to coextrusion molding using a compact T die extruder (Labo-plastomill available from Toyo Seiki Seisaku-sho, LTD.), and a base film of two-layer structure comprising the resin layer (A) having a thickness of 40 µm and the resin layer (B) having a thickness of 60 µm was obtained.

### (Preparation of pressure sensitive adhesive)

An energy ray curable-type pressure sensitive adhesive composition was obtained by mixing 100 mass parts of copolymer (Mw: 500,000) provided by copolymerization of 95 mass parts of n-butyl acrylate and 5 mass parts of acrylic acid, 120 mass parts of urethane acrylate oligomer (Mw: 8,000), 5 mass parts of isocyanate-based curing agent (Coronate L available fromNIPPON POLYURETHANE INDUSTRY CO., LTD.), and 4 mass parts of photopolymerization initiator (IRGACURE 184 available from Ciba Specialty Chemicals Inc).

The obtained energy ray curable-type pressure sensitive adhesive composition was applied to the release treatment surface of a release sheet treated with silicone treatment (SP-PET38111(S) available from LINTEC Corporation) to have a film thickness after drying of 10 µm, and dried at 100°C for 1 minute to form a pressure sensitive adhesive layer, which was then applied to the surface of the above base film at the side of the resin layer (A) thereby to transfer the pressure sensitive adhesive layer to the base film, and a dicing sheet was thus obtained.

### <Examples 2-13>

Dicing sheets were manufactured in the same manner as that in Example 1 except that the materials for the resin layer (A) and the resin layer (B) were changed to those listed in Table 1.

### <Example 14>

When a base film was formed as in Example 1, the base film of a single layer structure consisting of the resin layer (A) with a thickness of 100 µm was obtained without using raw material for extrusion of the resin layer (B), and a dicing sheet was manufactured in the same manner as that in Example 1.

### <Examples 15-18 and Comparative Examples 1-3>

Dicing sheets were manufactured in the same manner as that in Example 14 except that the materials for the resin layer (A) were changed to those listed in Table 1.

Materials used in each example are as follows.

### <Resin layer (A)>

### Norbornene-based resin (a1)

- Cycloolefin copolymer (product name: TOPAS (registered trademark) 7010, available from POLYPLASTICS CO., LTD., density at 23°C: 1.02 g/cm³, liquefaction temperature (result obtained based on Exemplary Test 2 as will be described later, here and hereinafter) : 136°C, MFR at a temperature of 230°C and a load of 2.16 kgf: 11 g/10 min)
- Cycloolefin copolymer (product name: TOPAS (registered trademark) 8007, available from POLYPLASTICS CO., LTD., density at 23°C: 1.02 g/cm³, liquefaction temperature: 142°C, MFR at a temperature of 230°C and a load of 2.16 kgf: 12 g/10 min)
- Cycloolefin copolymer (product name: TOPAS (registered trademark) 5013, available from POLYPLASTICS CO., LTD., density at 23°C: 1.02 g/cm³, liquefaction temperature: 175°C)
- Cycloolefin copolymer (product name: APEL (registered trademark) APL6509T, available from Mitsui Chemicals, Inc., density at 23°C: 1.02 g/cm³, liquefaction temperature: 130°C)
- Cycloolefin copolymer (product name: APEL (registered trademark) APL6011T, available from Mitsui Chemicals, Inc., density at 23°C: 1.02 g/cm³, liquefaction temperature: 152°C)

### Styrene-based elastomer (a2)

- Styrene-ethylene-butylene-styrene copolymer (hydrogenated product of styrene-butadiene copolymer) (SEBS, product name: Tuftec (registered trademark) H1041, available fromAsahi Kasei Corp., styrene content ratio: 30 mass%)
- Styrene-ethylene-butylene-styrene copolymer (hydrogenated product of styrene-butadiene copolymer) (SEBS, product name: Tuftec (registered trademark) H1221, available from Asahi Kasei Corp., styrene content ratio: 12 mass%)
- Styrene-ethylene/propylene-styrene copolymer (hydrogenated product of styrene-isoprene copolymer) (SEPS, product name: Kraton (registered trademark) G1730, available from Kraton Polymer Japan, styrene content ratio: 21 mass%)
- Non-hydrogenated product of styrene-butadiene copolymer (SBS, product name: Kraton (registered trademark) DKX405, available from Kraton Polymer Japan, styrene content ratio: 24 mass%)

### First olefin-based resin (a3)

- Low-density polyethylene (product name: SUMIKATHENE (registered trademark) L705, available from Sumitomo Chemical Company, Limited, density at 23°C: 0.919 g/cm³)
- Polypropylene (product name: Prime Polypro (registered trademark) F-744NP, available from Prime Polymer Co., Ltd.)

### <Resin layer (B)>

- Ethylene-methacrylic acid copolymer (product name: Nucrel (registered trademark) N0903HC, available from DUPONT-MITSUI POLYCHEMICALS CO., LTD., content of acid originated from MAA: 9 mass%)
- Random Polypropylene (product name: Novatec PP FX4E, available from Japan Polypropylene Corporation)
- Ethylene-methacrylic acid copolymer (product name: ACRYFT (registered trademark) W201, available from Sumitomo Chemical Company, Limited, tensile elastic modulus at 23°C: 65 Mpa (measurement method is the same as that in Exemplary Test 1))

Compositions of the above examples and comparative examples are collectively listed in Table 1. Each numerical value in Table 1 represents the mass parts of each component.

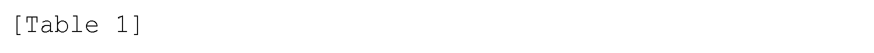

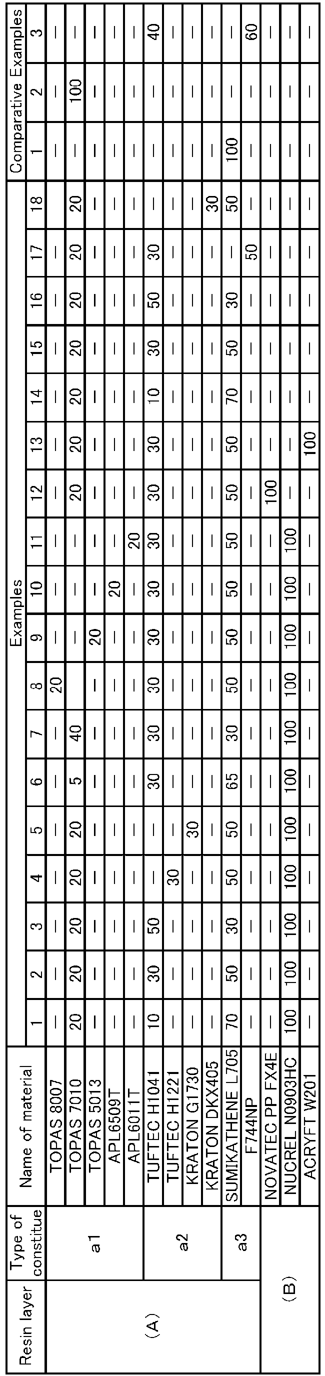

### <Exemplary Test 1> (Measurement of tensile elastic modulus)

Resin films having a thickness of 100 µm were manufactured through the same methods as those for the base films used in the examples and the comparative examples. Each resin film obtained in such a manner was cut into a test specimen of 15 mm×140 mm, and the tensile elastic modulus at 23°C was measured in compliance with JIS K7161: 1994 and JIS K7127: 1999. Specifically, tensile test was performed for the above test specimen with a rate of 200 mm/min using a tensile tester (Autograph AG-IS 500N available from SHIMADZU CORPORATION) after setting the distance between chucks to be 100 mm, thereby to measure the tensile elastic modulus (unit: MPa). Measurement of the tensile elastic modulus was performed in each of the extrusion direction (machine direction: MD) and the perpendicular direction thereto (cross machine direction: CD) at the time of molding the resin film, and the average value of these measurement results was determined to represent the tensile elastic modulus of the base film corresponding to the resin film. Results of the tensile elastic modulus are listed in Table 2.

### <Exemplary Test 2> (Measurement of liquefaction temperature)

To measure the liquefaction temperature of the norbornene-based resin (a1) used in each of the examples and the comparative examples, a "Koka"-type flow tester (Flowtester Capillary Rheometer, model number: CFT-100D, available from SHIMADZU CORPORATION) and a die having a hole shape of ϕ2.0 mm and a length of 5.0 mm were used with a load of 49.05 N to measure a stroke displacement rate (mm/min) varying as the temperature rising, while rising the temperature of the norbornene-based resin (a1) as a measurement sample with a rate of temperature rise of 10°C/min, and a temperature dependency chart of the stroke displacement rate of the norbornene-based resin (a1) was obtained. From this temperature dependency chart, the liquefaction temperature was determined as a temperature at which the stroke displacement rate became minimum after passing over the peak obtained beyond the softening point. Results of the liquefaction temperature are as previously described.

### <Exemplary Test 3> (Measurement of total luminous transmittance)

Resin films having a thickness of 100 µm were manufactured through the same methods as those for the base films used in the examples and the comparative examples. For each resin film obtained in such a manner, total luminous transmittance measurement (UV-VIS, measurement wavelengths: 300-400 nm) was performed using a spectrophotometer (UV-3600 available from SHIMADZU CORPORATION). Among the obtained values, the minimum value was determined to represent the total luminous transmittance of the base film corresponding to the resin film. Results of the total luminous transmittance are listed in Table 2.

### <Exemplary Test 4> (Observation of dicing debris)

After applying the pressure sensitive adhesive layer of each dicing sheet manufactured according to the examples and the comparative examples to an uncut BGA-type package module and then setting them on a dicing apparatus (DFD-651 available from DISCO Corporation), dicing was performed under the conditions below:
- work (adherend): silicon wafer;
- work size: 6 inches diameter, 350 µm thickness;
- dicing blade: 27HEEE available from DISCO Corporation;
- blade rotating speed: 50,000 rpm;
- dicing speed: 10 mm/sec;
- cut-into depth: cutting into the base film with a depth of 20 µm from the interface with the pressure sensitive adhesive layer; and
- dicing size: 10 mm×10 mm.

Thereafter, the cut chips were removed by irradiating ultraviolet rays (160 mJ/cm²) from the base film side. Among lengthwise and breadthwise dicing lines, one lengthwise line and one breadthwise line located near the respective centers were subjected to a test in which the number of filament-like debris particles of a length of 100 µm or more occurring on each line was counted using a digital microscope (VHX-100 available from KEYENCE CORPORATION, magnification: ×100). Measurement results were evaluated according to the criteria below. Evaluation results are listed in Table 2.
A: the number of filament-like debris particles was 0 to 10
B: 11 to 15
C: 16 or more

### <Exemplary Test 5> (Expandability test)

After applying a 6-inch silicon wafer to the pressure sensitive adhesive layer of each dicing sheet manufactured according to the examples and the comparative examples, the dicing sheet was attached to a flat frame and the wafer was fully cut into chips of 10 mm square using a diamond blade of 20 µm thickness. The dicing sheet was then pulled down under two conditions, i.e., pulled down 5 mm with a speed 300 mm/min and pulled down 10 mm with a speed of 600 mm/min using an expanding jig (Die Bonder CSP-100VX available from NEC Machinery Corporation). Presence or absence of fracture of the dicing sheet at that time was confirmed. Results were evaluated according to the criteria below. Evaluation results are listed in Table 2.
A: when fracture was not confirmed under both of the two conditions
B: when fracture was confirmed under either one condition
C: when fracture was confirmed under both of the two conditions

### <Exemplary Test 6> (Evaluation of handling ability)

When the above Exemplary Test 4 (Observation of dicing debris) was carried out, the dicing was performed using a fully-automatic dicing apparatus (DFD-651 available from DISCO Corporation). In this operation, the handling ability during from the supply of samples to the recovery thereof was evaluated according to the criteria below. Evaluation results are listed in Table 2.
A: when no particular problem occurred
B: when some transport error occurred and/or when the dicing sheet was loosened, after reattached to the wafer cassette, to be in contact with another dicing sheet placed on the lower stage

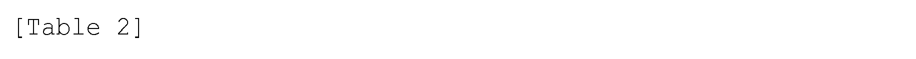

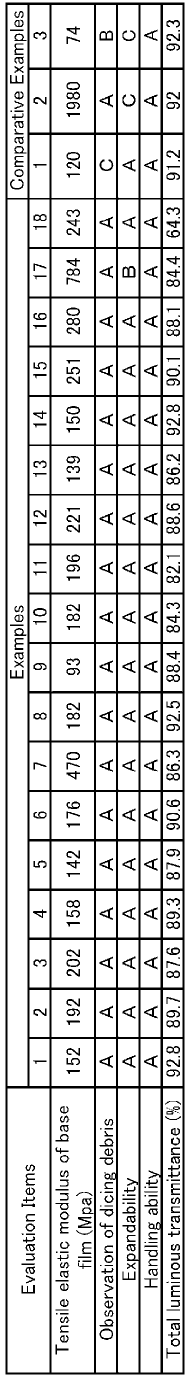

As apparent from Table 2, the dicing sheets manufactured according to the examples were less likely to generate dicing debris during the dicing process, and had excellent expandability during the expanding process and excellent handling ability during the dicing process. In contrast, the dicing sheet of Comparative Example 1, not containing the norbornene-based resin (a1) and the styrene-based elastomer (a2), had excellent expandability, but generated dicing debris during the dicing process. With regard to Comparative Example 3 not containing the norbornene-based resin (a1), the occurrence of dicing debris was more observed than the examples, and the dicing sheet fractured in the expanding process, thus exhibiting poor expandability. Comparative Example 2, consisting only of the norbornene-based resin (a1), was less likely to generate dicing debris, but the dicing sheet fractured in the expanding process, thus exhibiting poor expandability.

### [Industrial Applicability]

The base film for a dicing sheet and the dicing sheet according to the present invention can be preferably used for dicing of semiconductor wafers and various kinds of packages, etc.

### [Description of Reference Numerals]

- 1: Dicing sheet
- 2: Base film (Resin layer (A)/Resin layer (B))
- 3: Pressure sensitive adhesive layer

## Claims

1. A dicing sheet base film comprising a resin layer (A), the resin layer (A) comprising: a norbornene-based resin (a1) that is a thermoplastic resin containing a structural unit derived from a norbornene-based compound; a styrene-based elastomer (a2); and an olefin-based thermoplastic resin (a3) other than the norbornene-based resin (a1) and other than the styrene-based elastomer (a2).

2. The dicing sheet base film as recited in claim 1, wherein the styrene-based elastomer (a2) comprises a styrene-conjugate diene copolymer.

3. The dicing sheet base film as recited in claim 1 or 2, wherein the styrene-based elastomer (a2) contains styrene with a content ratio of 5 mass% or more and 50 mass% or less.

4. The dicing sheet base film as recited in any one of claims 1 to 3, wherein the styrene-based elastomer (a2) in the resin layer (A) has a content of 10 mass% or more and 60 mass% or less.

5. The dicing sheet base film as recited in any one of claims 1 to 4, wherein the norbornene-based resin (a1) has a density of 0.98 g/cm³ or more at 23°C.

6. The dicing sheet base film as recited in any one of claims 1 to 5, wherein the norbornene-based resin (a1) has a liquefaction temperature of 225°C or lower.

7. The dicing sheet base film as recited in any one of claims 1 to 6, wherein the norbornene-based resin (a1) in the resin layer has a content of 3 mass% or more and 40 mass% or less.

8. The dicing sheet base film as recited in any one of claims 1 to 7, wherein the resin layer (A) has a total luminous transmittance of 75% or more in an ultraviolet region.

9. The dicing sheet base film as recited in any one of claims 1 to 8, wherein the dicing sheet base film comprises a resin layer (B) placed at a side of one of surfaces of the resin layer (A), and the resin layer (B) comprises at least one layer.

10. The dicing sheet base film as recited in claim 9, wherein the resin layer (B) has a tensile elastic modulus of 50 MPa or more and 500 MPa or less at 23°C and a fracture elongation of 100% or more.

11. The dicing sheet base film as recited in claim 9 or 10, wherein the resin layer (B) contains an ethylene- (meth) acrylic acid copolymer.

12. The dicing sheet base film as recited in any one of claims 1 to 11, wherein the dicing sheet base film has a tensile elastic modulus of 80 MPa or more and 1,000 MPa or less at 23°C.

13. A dicing sheet comprising: the dicing sheet base film as recited in any one of claims 1 to 12; and a pressure sensitive adhesive layer placed on the resin layer (A) of the film.
